**Europäisches Patentamt**

**European Patent Office**

**Office européen des brevets**

(11) Numéro de publication: **0 274 949 B1**

# (12) FASCICULE DE BREVET EUROPEEN

(45) Date de publication de fascicule du brevet: **11.03.92**   (51) Int. Cl.⁵: **H02H 7/00**, B05B 5/025

(21) Numéro de dépôt: **87402842.6**

(22) Date de dépôt: **14.12.87**

(54) **Procédé de contrôle et de protection contre les arcs électriques dans un dispositif générateur de haute-tension et dispositif mettant en oeuvre ce procédé.**

(30) Priorité: **19.12.86 FR 8617876**

(43) Date de publication de la demande:
**20.07.88 Bulletin 88/29**

(45) Mention de la délivrance du brevet:
**11.03.92 Bulletin 92/11**

(84) Etats contractants désignés:
**BE CH DE ES GB IT LI NL SE**

(56) Documents cités:
**EP-A- 0 135 440
DE-A- 3 219 236
US-A- 4 133 413**

(73) Titulaire: **SAMES S.A.
Z.I.R.S.T. Chemin de Malacher
F-38240 Meylan(FR)**

(72) Inventeur: **Thome, Caryl
15 Rue Casimir Brenier
F-38120 Saint Egrève(FR)**
Inventeur: **Burtin, Jean-Pierre
18 rue du Drac
F-38120 Saint Egrève(FR)**

(74) Mandataire: **CABINET BONNET-THIRION
95 Boulevard Beaumarchais
F-75003 Paris(FR)**

## Description

L'invention se rapporte à un procédé de contrôle et de protection contre les arcs électriques, mis en oeuvre dans un dispositif de production de haute-tension et notamment un dispositif de ce genre faisant partie d'une installation de projection électrostatique d'un produit de revêtement tel que de la peinture ou de la poudre thermofusible. L'invention concerne aussi un appareil générateur de haute-tension incorporant des moyens mettant en oeuvre ledit procédé.

Dans une installation du type mentionné ci-dessus, la peinture pulvérisée en fines gouttelettes est généralement chargée par une haute-tension avant de quitter le projecteur et se dirige vers l'objet à peindre, relié à la terre.

En fonction de l'évolution de certains paramètres tels que la valeur de la haute-tension, la forme de l'objet et son éloignement du projecteur, des arcs électriques peuvent se produire, ce que peut provoquer des dégâts importants, spécialement si le produit est inflammable.

Un dispositif générateur de tension de ce genre comprend généralement des moyens formant source de basse-tension continue, un convertisseur continu-alternatif haute-fréquence, alimenté par la source de basse-tension continue (il s'agit généralement d'un oscillateur, d'un hacheur ou de tout autre dispositif analogue), un transformateur élévateur de tension et un redresseur-multiplicateur de tension, de structure classique comprenant un montage en cascade de diodes et de condensateurs. Le primaire du transformateur est alimenté par le convertisseur et le secondaire est relié à l'entrée basse-tension du redresseur-élévateur. Tous ces éléments sont répartis entre un sous-ensemble fixe et un sous-ensemble mobile, ce dernier formant par exemple le projecteur de peinture manipulé par un opérateur ou fixé à un bras de robot. Les deux sous-ensembles sont généralement reliés par un toron renfermant, outre le conduit d'alimentation en peinture, plusieurs conducteurs électriques. Parmi ceux-ci, on note notamment un conducteur dit "conducteur de retour" reliant l'une des bornes de l'entrée basse-tension du redresseur-multiplicateur de tension à une impédance (généralement une résistance de forte valeur) connectée à la terre dans ledit sous-ensemble fixe. On peut, par ce moyen simple, mesurer et "surveiller" la valeur du courant haute-tension ainsi que ses variations, ce qui permet, dans une certaine mesure, de prévoir l'imminence d'un arc électrique. La mesure de ce courant est, par exemple, mise à profit pour piloter un circuit limiteur de tension de la source de basse-tension continue.

Ce principe est mis en oeuvre, par exemple, dans le dispositif décrit dans le document DE-A 32 19 236.

Les autres conducteurs du toron sont, notamment, les deux fils reliant la source de basse-tension et le convertisseur continu-alternatif si ce dernier est dans le sous-ensemble mobile ou bien les deux fils reliant la sortie du convertisseur continu-alternatif au primaire du transformateur-élévateur, dans le cas où ledit convertisseur est situé dans le sous-ensemble fixe. Dans le premier cas, les deux fils transmettent une tension continue et dans l'autre cas, ils transmettent une tension alternative dite "de haute-fréquence" (de l'ordre de 20 à 25kHz).

Le mauvais état de l'un de ces conducteurs peut aussi être une cause de production d'arcs électriques. On a déjà proposé de surveiller par des moyens spécifiques, la continuité et l'isolement des conducteurs reliant lesdits sous-ensembles fixe et mobile.

L'invention propose de réaliser cette surveillance par des moyens simples, efficaces et peu coûteux en exploitant le fait que la capacité parasite du transformateur-élévateur réinjecte normalement une certaine composante résiduelle haute-fréquence sur ledit conducteur de retour, cette composante résiduelle pouvant donc être captée et mesurée dans le sous-ensemble fixe. On a en effet pu observer que, quel que soit le défaut de l'un quelconque des conducteurs mentionnés ci-dessus, il provoquait la disparition ou une chute sensible du niveau de ladite composante parasite. L'invention met à profit ce phénomène.

Dans cet esprit, l'invention concerne en premier lieu un procédé de contrôle et de protection contre les arcs électriques pour des moyens d'élaboration de haute-tension dans lesquels un pôle d'une entrée basse-tension d'un redresseur-multiplicateur de tension alimenté par un convertisseur continu-alternatif haute-frequence et logé dans un sous-ensemble mobile est mis à la terre dans un sous-ensemble fixe par l'intermédiaire d'un fil conducteur connecté entre lesdits sous-ensembles fixe et mobile, caractérisé en ce qu'il consiste à capter et mesurer un signal alternatif résiduel haute-fréquence, réinjecté sur ledit fil conducteur, à comparer le résultat de cette mesure à une valeur de référence, éventuellement variable, et à inhiber lesdits moyens d'élaboration de haute-tension lorsque, ladite mesure diminuant, la différence entre ladite mesure et ladite valeur de référence atteint un seuil prédéterminé.

L'invention concerne également un dispositif générateur de haute-tension, notamment pour une installation de projection électrostatique d'un produit de revêtement, du type comportant des moyens formant source de basse-tension continue, un convertisseur continu-alternatif haute-fréquence, tel que par exemple un oscillateur, un hacheur ou analogue, alimenté par ladite source basse-tension, un transformateur-élévateur dont le primaire est relié à la sortie dudit convertisseur et un redresseur-multiplicateur de tension dont une entrée basse-tension est reliée au secondaire dudit transformateur-élévateur, certains de ces éléments étant montés dans un sous-ensemble fixe et d'autres, dont ledit redresseur-élévateur, étant montés dans un sous-ensemble mobile relié audit sous-ensemble fixe par plusieurs conducteurs dont un conducteur de retour reliant un pôle de ladite entrée basse-tension à la terre par l'intermédiaire d'au moins une impédance située dans ledit sous-ensemble fixe, caractérisé en ce que ledit sous-ensemble fixe renferme des moyens de mesure d'une composante résiduelle haute-fréquence, couplés audit conducteur de retour, un moyen comparateur à deux entrées et une source de tension de référence, les sorties desdits moyens de mesure et de ladite source de référence étant respectivement reliés aux deux entrées dudit moyen comparateur et en ce que la sortie de ce moyen comparateur est connectée à des moyens de disjonction ou d'inhibition agencés pour interrompre la circulation de courant électrique vers ledit sous-ensemble mobile lorsque ledit moyen comparateur change d'état en réponse à une diminution du signal déliveré par lesdits moyens de mesure.

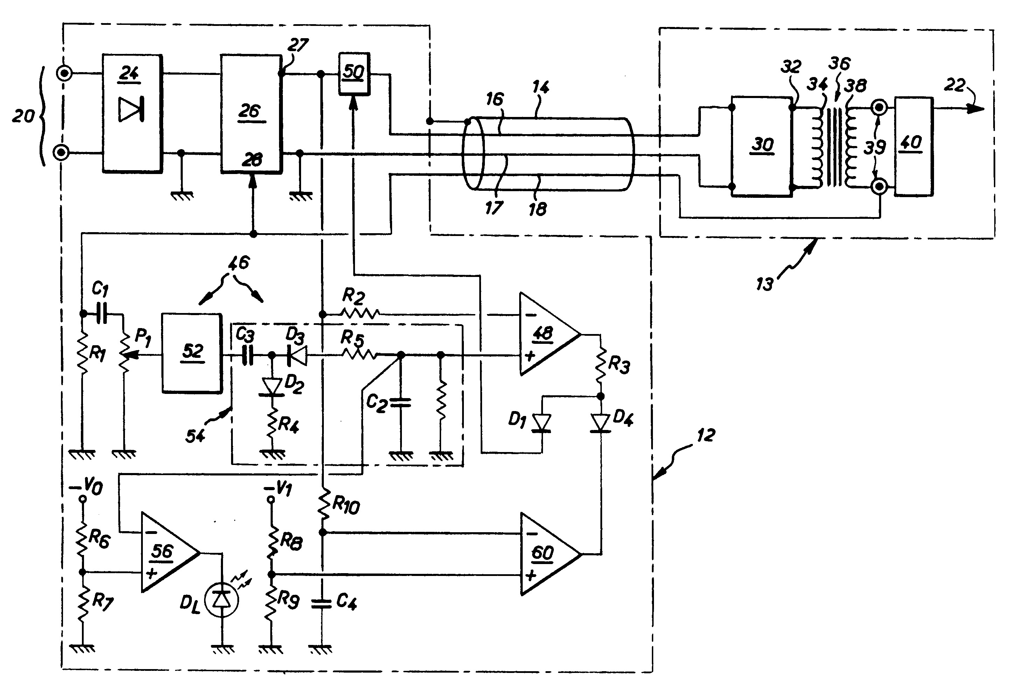

L'invention sera mieux comprise et d'autres avantages de celle-ci apparaîtront plus clairement à la lumière de la description qui va suivre, donnée uniquement à titre d'exemple et faite en référence au dessin annexé dans lequel:

- la figure unique est un schéma de principe d'un dispositif générateur de haute-tension, mettant en oeuvre le principe de l'invention.

Sur le schéma, on a représenté à titre d'exemple, une partie d'une installation de projection électrostatique d'un produit de revêtement tel que de la peinture et plus particulièrement l'appareil générateur de haute-tension qui se répartit entre un sous-ensemble fixe 12 et un sous-ensemble mobile 13 proche du pulvérisateur de peinture ou combiné à celui-ci. Un toron 14, renferme des conduits de peinture et d'air comprimé, non représentés, et plusieurs conducteurs électriques de liaison 16, 17 et 18. Ce dernier est appelé "conducteur de retour" par commodité, pour des raisons qui apparaîtront plus loin.

Le dispositif comporte plusieurs éléments répartis entre les deux sous-ensembles et interconnectés globalement entre les bornes 20 du réseau de distribution alternatif et une électrode d'ionisation 22. Les éléments contenus dans le sous-ensemble fixe sont: un redresseur 24 alimentant un circuit de régulation ou de limitation de tension 26, classique, délivrant à sa sortie 27 une basse-tension continue variable en fonction de la valeur d'une tension de pilotage appliquée à une entrée de commande 28. L'ensemble du redresseur 24 et du circuit de régulation ou de limitation 26 constitue donc des moyens formant source de basse-tension continue. Cette tension continue est appliquée par les deux conducteurs 16, 17 du toron 14 aux bornes d'alimentation d'un convertisseur continu-alternatif haute-fréquence 30 situé dans le sous-ensemble mobile 13. Ce convertisseur est ici un oscillateur dont la fréquence est, par exemple, comprise entre 20 et 25kHz. Par conséquent, l'amplitude des oscillations délivrées à la sortie 32 de l'oscillateur est fonction de la valeur de la tension d'alimentation basse-tension de cet oscillateur, c'est-à-dire de la tension élaborée par le circuit de régulation ou de limitation 26. La sortie 32 de l'oscillateur est connectée au primaire 34 d'un transformateur-élévateur 36 dont le secondaire 38 est connecté à l'entrée basse-tension 39 d'un redresseur-élévateur de tension 40. Ce dernier comporte classiquement une cascade de diodes et de condensateurs et sa sortie est connectée à l'électrode 22. De façon connue, un pôle de l'entrée basse-tension 39 (celui que est relié au "pied" de l'enroulement secondaire 38) est connecté audit "conducteur de retour" lequel est relié à son autre extrémité, dans le sous-ensemble 12, à une impédance, ici essentiellement une résistance $R_1$ connectée à la terre. Par conséquent, la tension continue disponible aux bornes de cette résistance est représentative de l'intensité du courant haute-tension. Cette tension est donc appliquée à l'entrée 28 du circuit 26 pour faire varier la tension d'alimentation de l'oscillateur 30 (donc la haute-tension) de façon à au moins limiter la haute-tension ou même à faire disjoncter le dispositif si le courant haute-tension et/ou sa variation augmentent, ce qui est l'indice d'un risque d'arcs électriques. Tout cet agencement est connu et ne nécessite donc pas d'être décrit plus en détail. La répartition desdits éléments décrits ci-dessus, entre le sous ensemble fixe et le sous-ensemble mobile, peut être différente. En particulier, l'oscillateur peut se trouver dans le sous-ensemble fixe, auquel cas les conducteurs 16 et 17 appliquent une basse-tension alternative haute-fréquence au primaire du transformateur-élévateur situé dans le sous-ensemble mobile.

Il se trouve que la capacité parasite du transformateur-élévateur 36 n'est jamais négligeable de sorte qu'une composante résiduelle alternative haute-fréquence se trouve réinjectée sur le conducteur de retour. Cette composante résiduelle se trouve donc disponible et exploitable aux bornes de la résistance $R_1$.

On a trouvé que la présence de cette composante résiduelle était un indice sûr de la continuité et de l'isolement, donc du bon état, des conducteurs du toron 14. En effet, si l'un de ces conducteurs est coupé ou mal isolé, la composante résiduelle haute fréquence disparaît ou est sensiblement atténuée. Ce phénomène est donc exploité selon l'invention, en captant et en mesurant la composante alternative résiduelle haute-fréquence réinjectée sur ledit conducteur de retour, en comparant le résultat de cette mesure à une valeur de référence, ici variable, et en inhibant les moyens d'élaboration de la haute-tension lorsque la différence entre ladite mesure et ladite valeur de référence atteint ou franchit un seuil prédéterminé. Ladite valeur de référence est, selon l'exemple, représentative de la tension de sortie du circuit 26.

Des moyens de mesure 46 de la composante résiduelle haute-fréquence sont prévus dans le sous-ensemble fixe 12 et couplés au conducteur de retour 18 (c'est-à-dire aux bornes de la résistance $R_1$) tandis qu'un moyen comparateur 48 tel qu'un amplificateur opérationnel à deux entrées différentielles, a l'une de ses entrées connectée à la sortie des moyens de mesure 46 et l'autre entrée reliée, via une résistance $R_2$ ou tout autre réseau adapté, à la sortie 27 du circuit 26. La sortie du moyen comparateur 48 est reliée, via une liaison en série d'une résistance $R_3$ et d'une diode $D_1$ à des moyens de disjonction ou d'inhibition 50 agencés pour interrompre la circulation de courant électrique vers ledit sous-ensemble mobile 13. Ici, il s'agit par exemple d'un disjoncteur 50 inséré en série dans la liaison entre le circuit 26 et le convertisseur 30.

Plus précisément, les moyens de mesure 46 comprennent successivement un moyen de prélèvement de ladite composante résiduelle (à savoir un simple condensateur $C_1$ relié au point commun de la résistance $R_1$ et du conducteur de retour 18), des moyens formant adaptateur de niveau, sous la forme d'un potentiomètre $P_1$, un circuit adaptateur d'impédances 52 et des moyens de redressement et de filtrage 54 dont la tension de sortie, aux bornes d'un condensateur $C_2$, est représentative de la valeur moyenne de la composante résiduelle haute-fréquence. La sortie des moyens de redressement et de filtrage 54 est aussi celle desdits moyens de mesure 46. Elle est donc reliée à une entrée du comparateur 46. Le potentiomètre $P_1$ est simplement connecté entre une borne du condensateur $C_1$ et la terre et son curseur est relié au circuit adaptateur d'impédance 52. Ce dernier n'est pas représenté en détail; il peut par exemple être d'un type connu comprenant un étage à transistor monté en émetteur commun. Les moyens de redressement et de filtrage 54 comportent quant à eux, un condensateur de liaison $C_3$ connecté entre la sortie du circuit 52 et le point commun de deux diodes de redressement, l'une $D_2$ reliée à la terre

par une résistance $R_4$ et l'autre $D_3$ reliée au condensateur $C_2$ par une résistance $R_5$. La sortie de ces moyens de redressement et de filtrage 54 est, par ailleurs, reliée à une entrée d'un amplificateur différentiel 56 autour duquel est constitué un circuit de contrôle de réglage. L'autre entrée de l'amplificateur 56 est polarisée par un pont de deux résistances $R_6$, $R_7$ connectées en série entre un potentiel de référence $-V_0$ et la terre. La sortie de l'amplificateur 56 alimente une diode électroluminescente DL.

Le montage est complété par un circuit d'inhibition du moyen comparateur 48, actif seulement à la mise sous tension pour éviter le déclenchement du disjoncteur 50. Ce montage comporte un comparateur 60 sous la forme d'un autre amplificateur différentiel, dont la sortie est reliée par une diode $D_4$ au point commun de la résistance $R_3$ et de la diode $D_1$. Les deux diodes $D_1$ et $D_4$ ont leurs cathodes communes. L'entrée non inverseuse de cet amplificateur différentiel est polarisée en étant reliée au point commun de deux résistances $R_8$, $R_9$ connectées en série entre un potentiel de référence $-V_1$ et la terre. L'entrée inverseuse de ce même amplificateur différentiel est reliée par une résistance $R_{10}$ à la sortie 27 du circuit 26. Un condensateur $C_4$ est connecté entre cette même entrée inverseuse et la terre.

Le fonctionnement est des plus simples et découle avec évidence de la description que précède. La mise en service est précédée d'une phase de réglage destiné à prendre en compte la longueur du toron 14, donc celle du conducteur de retour 18. En effet, à la fréquence considérée, ce conducteur présente une impédance non négligeable se traduisant par une certaine atténuation de la composante résiduelle réinjectée. C'est la raison pour laquelle on ajuste le potentiomètre $P_1$ pour faire en sorte que la tension disponible aux bornes du condensateur $C_2$ soit juste suffisante pour provoquer l'allumage de la diode DL. A partir de ce moment, la tension continue disponible aux bornes du condensateur $C_2$, qui est représentative de la valeur moyenne de la composante parasite prélevée par le condensateur $C_1$ est comparée à une autre tension continue représentative de la valeur de la basse-tension alimentant l'oscillateur 30. Cette tension est éventuellement variable dans les conditions indiquées ci-dessus. Si la tension disponible aux bornes du condensateur $C_2$ devient inférieure à la valeur de référence appliquée sur l'autre entrée du comparateur 48, celui-ci bascule et actionne le disjoncteur 50.

Dans le cas mentionné ci-dessus où le convertisseur 30 se trouve dans le sous-ensemble fixe 12, l'entrée inverseuse du comparateur 48 peut être reliée à la sortie de ce convertisseur, par l'intermédiaire de moyens de redressement adaptés. Le fonctionnement est alors comparable à celui qui vient d'être décrit.

## Revendications

1. Procédé de contrôle et de protection contre les arcs électriques pour des moyens d'élaboration de haute-tension dans lesquels un pôle d'une entrée basse-tension (39) d'un redresseur-multiplicateur de tension (40) alimenté par un convertisseur continu-alternatif haute-fréquence (30) et logé dans un sous-ensemble mobile est mis à la terre dans un sous-ensemble fixe par l'intermédiaire d'un fil conducteur (18) connecté entre lesdits sous-ensembles fixe et mobile, caractérisé en ce qu'il consiste à capter et mesurer un signal alternatif résiduel haute fréquence, réinjecté sur ledit fil conducteur (18), à comparer (48) le résultat de cette mesure à une valeur de référence (27), éventuellement variable, et à inhiber (50) lesdits moyens d'élaboration de haute-tension lorsque, ladite mesure diminuant, la différence entre ladite mesure et ladite valeur de référence atteint un seuil prédéterminé.

2. Procédé selon la revendicaiton 1, caractérisé en ce que ladite valeur de référence est représentative d'une tension d'alimentation continue (26, 27) d'un convertisseur continu-alternatif (30), fournissant l'énergie électrique nécessaire audit redresseur-multiplicateur de tension.

3. Procédé selon la revendication 1, caractérisé en ce que ladite valeur de référence est représentative de la puissance alternative délivrée par un convertisseur continu-alternatif (30) fournissant l'énergie électrique nécessaire audit redresseur-multiplicateur de tension, ce convertisseur étant situé dans ledit sous-ensemble fixe.

4. Dispositif générateur de haute-tension, notamment pour une installation de projection électrostatique d'un produit de revêtement, du type comportant des moyens formant source de basse-tension continue (24, 26), un convertisseur continu-alternatif haute fréquence (30), tel que par exemple un oscillateur, un hacheur ou analogue, alimenté par ladite source basse-tension, un transformateur -élévateur (36) dont le primaire est relié à la sortie dudit convertisseur et un redresseur-multiplicateur de tension (40) dont une entrée basse-tension est reliée au secondaire dudit transformateur-élévateur, certains de ces éléments étant montés dans un sous-ensemble fixe (12) et d'autres, dont ledit redresseur-élévateur, étant montés dans un sous-ensemble mobile (13) relié audit sous-ensemble fixe par plusieurs conducteurs dont un conducteur de retour (18) reliant un pôle de ladite entrée basse-tension à la terre par l'intermédiaire d'au moins une impédance ($R_1$) située dans ledit sous-ensemble fixe, caractérisé en ce que ledit sous-ensemble fixe renferme des moyens de mesure d'une composante résiduelle haute-fréquence (46), couplés audit conducteur de retour (18), un moyen comparateur à deux entrées (48) et une source de tension de référence (26), les sorties desdits moyens de mesure et de ladite source de référence étant respectivement reliés aux deux entrées dudit moyen comparateur et en ce que la sortie de ce moyen comparateur est connectée à des moyens de disjonction ou d'inhibition (50) agencés pour interrompre la circulation de courant électrique vers ledit sous-ensemble mobile (13) lorsque ledit moyen comparateur change d'état en réponse à une diminution du signal délivré par lesdits moyens de mesure.

5. Dispositif selon la revendication 4, caractérisé en ce que lesdits moyens de mesure de la composante résiduelle haute-fréquence (46) comportent:
   - un moyen de prélèvement ($C_1$) de cette composante résiduelle, par exemple un condensateur,
   - des moyens formant adaptateur de niveau ($P_1$) pour prendre en compte la longueur dudit conducteur de retour (18), et
   - des moyens de redressement et de filtrage (54) pour élaborer une tension continue représentative de ladite composante résiduelle haute-fréquence, la sortie de ces moyens de redressement et de filtrage étant connectée à une entrée dudit moyen comparateur (48).

6. Dispositif selon la revendication 5, caractérisé en ce qu'un circuit de contrôle de réglage (56, $R_6$, $R_7$, DL) par exemple à diode électroluminescente (DL), a une entrée reliée à la sortie desdits moyens de redressement et de filtrage (54).

7. Dispositif selon l'une des revendications 4 à 6, caractérisé en ce que l'autre entrée dudit moyen comparateur (48) est reliée à la sortie (27) desdits moyens formant source de basse-tension continue (24, 26).

8. Dispositif selon l'une des revendications 4 à 6, caractérisé en ce que ledit convertisseur (30) étant logé dans ledit sous-ensemble fixe, l'autre entrée dudit moyen comparateur est reliée à la sortie de ce convertisseur, par l'intermédiaire de moyens de redressement adaptés.

## Claims

1. A process for monitoring and providing protection against electric arcs for high-tension voltage generating means in which a terminal of a low-voltage input (39) of a voltage rectifier-multiplier (40) which is supplied by a high-frequency dc-ac converter (30) and which is accommodated in a mobile sub-assembly is earthed in a fixed sub-assembly by way of a conductor wire (18) connected between said fixed and mobile sub-assemblies, characterised in that it comprises sensing and measuring a residual high-frequency ac signal which is re-injected into said conductor wire (18), comparing (48) the result of said measurement to a reference value (27) which is possibly variable, and disabling (50) said high-tension voltage generating means when, said measurement decreasing, the difference between said measurement and said reference value reaches a predetermined threshold.

2. A process according to claim 1 characterised in that said reference value is representative of a dc supply voltage (26, 27) for a dc-ac converter (30) providing the electrical energy required to said voltage rectifier-multiplier.

3. A process according to claim 1 characterised in that said reference value is representative of the ac power supplied by a dc-ac converter (30) supplying the electrical energy required to said voltage rectifier-multiplier, said converter being disposed in said fixed sub-assembly.

4. A high-tension voltage generating device, in particular for an installation for the electrostatic spraying of a coating product, of the type comprising means (24, 26) forming a low-tension dc voltage source, a high-frequency dc-ac converter (30) such as for example an oscillator, a chopper or the like, which is supplied by said low-tension voltage source, a step-up transformer (36) whose primary winding is connected to the output of said converter and a voltage rectifier-multiplier (40) of which a low-tension input is connected to the secondary winding of said step-up transformer, some of said elements being mounted in a fixed sub-assembly (12) and others including said rectifier-multiplier being mounted in a mobile sub-assembly (13) connected to said fixed sub-assembly by a plurality of conductors including a return conductor (18) connecting a terminal of said low-tension input to earth by way of at least one impedance ($R_1$) disposed in said fixed sub-assembly, characterised in that said fixed sub-assembly includes means (46) for measuring a residual high-frequency component, which are coupled to said return conductor (18), a comparator means (48) having two inputs, and a reference voltage source (26), the outputs of said measuring means and said reference source being respectively connected to the two inputs of the comparator means, and that the output of said comparator means is connected to circuit-breaker or disabling means (50) arranged to interrupt the flow of electric current to said mobile sub-assembly (13) when said comparator means changes in state in response to a reduction in the signal delivered by said measuring means.

5. A device according to claim 4 characterised in that said means (46) for measuring the residual high-frequency component comprise:
   - a means ($C_1$) for sampling said residual component, for example a capacitor,
   - means forming a level matching means ($P_1$) to take into account the length of said return conductor (18), and
   - rectifier and filter means (54) for producing a dc voltage which is representative of said residual high-frequency component, the output of said rectifier and filter means being connected to an input of said comparator means (48).

6. A device according to claim 5 characterised in that a regulating monitoring circuit (56, $R_6$, $R_7$, DL), for example with a light emitting diode (DL), has an input connected to the output of said rectifier and filter means (54).

7. A device according to one of claims 4 to 6 characterised in that the other input of said comparator means (48) is connected to the output (27) of said means forming a low-tension dc voltage source (24, 26).

8. A device according to one of claims 4 to 6 characterised in that, said converter (30) being accommodated in said fixed sub-assembly, the other input of said comparator means is connected to the output of said converter, by way of suitable rectifier means.

## Patentansprüche

1. Verfahren zur Steuerung von Hochspannungserzeugungseinrichtungen und zu deren Schutz gegen elektrische Lichtbögen, bei welchen Hochspannungseinrichtungen ein Pol eines Niederspannungseingangs (39) eines von einem Gleichspannungs/Hochfrequenzwechselspannungs-Wandler versorgten, sich in einer beweglichen Untereinheit befindenden Gleichrichter-Spannungsvervielfachers (40) über einen Leiter (18) zwischen der beweglichen und einer ortsfesten Untereinheit in dieser geerdet ist, dadurch gekennzeichnet, daß ein auf den Leiter (18) gekoppeltes Resthochfrequenzsignal erfaßt und gemessen wird (48), daß das Ergebnis dieser Messung mit einem gegebenenfalls veränderbaren Bezugswert (27) verglichen wird (48), und daß die Hochspannungserzeugungseinrichtung gesperrt wird (58), wenn bei sich verringerndem Meßwert der Unterschied zwischen dem Meßwert und dem Bezugswert einen vorgegebenen Grenzwert erreicht.

2. Verfahren nach Anspruch 1, dadurch gekennzeichnet, daß der Bezugwert repräsentativ für eine Speisegleichspannung (26, 27) eines Gleichspannungs/Wechselspannungs-Wandlers (30) ist, der die für den Gleichrichter/Spannungsvervielfacher notwendige elektrische Energie liefert.

3. Verfahren nach Anspruch 1, dadurch gekennzeichnet, daß der Bezugswert repräsentativ für die von einem Gleichspannungs/Wechselspannungs-Wandler (30) gelieferte Leistung ist, der die für den Gleichrichter/Spannungsvervielfacher notwendige elektrische Energie liefert und sich in der beweglichen Untereinheit befindet.

4. Hochspannungserzeuger, insbesondere für eine elektrostatische Zerstäuberanlage für ein Überzugsprodukt, mit Mitteln, die eine Niederspannungsgleichstromquelle (24, 26) bilden, mit einem Gleichspannungs/Hochfrequenzwechselspannungs-Wandler (30) wie zum Beispiel einem Oszillator, Zerhacker oder dergl., der von der Niederspannungsquelle gespeist wird, einem Aufwärtstransformator (36), dessen Primärwicklung mit dem Ausgang des Wandlers verbunden ist, und mit einem Gleichrichter-Spannungsvervielfacher (40), dessen Niederspannungseingang mit der Sekundärwicklung des Aufwärtstransformators verbunden ist, wobei einige dieser Komponenten sich in einer ortsfesten Untereinheit (12), andere, darunter der Gleichrichter-Vervielfacher, in einer beweglichen Untereinheit (13) befinden, die mit der ortsfesten Untereinheit über mehrere Leiter verbunden ist, von denen ein Rückleiter (18) einen Pol des Niederspannungseingangs mit Erde über wenigstens eine sich in der ortsfesten Untereinheit befindende Impedanz ($R_1$) verbindet, dadurch gekennzeichnet, daß die ortsfeste Untereinheit ein Meßmittel (46) für eine hochfrequente Restkomponente enthält, das mit dem Rückleiter (18) gekoppelt ist, sowie einen Vergleicher (48) mit zwei Eingängen und eine Bezugsspannungsquelle (26), wobei die Ausgänge des Meßmittels und der Bezugsspannungsquelle jeweils mit zwei Eingängen des Vergleichers verbunden sind, und daß der Ausgang des Vergleichers mit einer Trenn- oder Sperreinrichtung (50) verbunden ist, die so beschaffen ist, daß sie den Stromkreis zu der beweglichen Untereinheit (13) unterbricht, sobald der Vergleicher seinen Zustand infolge einer Verkleinerung des von dem Meßmittel gelieferten Signals wechselt.

5. Hochspannungserzeuger nach Anspruch 4, dadurch gekennzeichnet, daß das Meßmittel für die hochfrequente Restkomponente folgendes umfaßt:
   - ein Entnahmemittel ($C_1$) für diese Restkomponente, zum Beispiel einen Kondensator,
   - einen Pegeleinsteller ($P_1$) zur Berücksichtigung der Länge des Rückleiters (18), und
   - Gleichrichter- und Filtermittel (54) zur Gewinnung einer für die Resthochfrequenzkomponente repräsentativen Gleichspannung, wobei der Ausgang des Gleichrichter- und Filtermittels mit einem Eingang des Vergleichers (48) verbunden ist.

6. Hochspannungserzeuger nach Anspruch 5, dadurch gekennzeichnet, daß eine Einstellsteuerschaltung (56, $R_6$, $R_7$, DL), zum Beispiel eine Lumineszenzdiode (DL), einen mit dem Ausgang des Filter- und Gleichrichtermittels (54) verbundenen Eingang hat.

7. Hochfrequenzspannungserzeuger nach einem der Ansprüche 4 bis 6, dadurch gekennzeichnet, daß der andere Eingang des Vergleichers (48) mit dem Ausgang (27) der die Niederspannungsgleichstromquelle (24, 26) bildenden Einrichtung verbunden ist.

8. Hochspannungserzeuger nach einem der Ansprüche 4 bis 6, dadurch gekennzeichnet, daß sich der Wandler (30) in der ortsfesten Untereinheit befindet, und daß der andere Eingang des Vergleichers über angepaßte Gleichrichtermittel mit dem Ausgang des Wandlers verbunden ist.